Europäisches Patentamt

European Patent Office

Office européen des brevets

(19)

(11) Numéro de publication: **0 057 117**
**B1**

(12) **FASCICULE DE BREVET EUROPEEN**

(45) Date de publication du fascicule du brevet:
02.05.85

(21) Numéro de dépôt: 82400031.9

(22) Date de dépôt: 08.01.82

(51) Int. Cl.⁴: **H 04 N 5/38, H 04 N 5/16,
H 04 N 9/64, H 03 G 11/02**

(54) **Dispositif de limitation d'un signal de luminance.**

(30) Priorité: **23.01.81 FR 8101290**

(43) Date de publication de la demande:
**04.08.82 Bulletin 82/31**

(45) Mention de la délivrance du brevet:
**02.05.85 Bulletin 85/18**

(84) Etats contractants désignés:
**AT BE CH DE GB IT LI LU NL SE**

(56) Documents cités:
**DE - A - 2 048 045
US - A - 3 393 369**

(73) Titulaire: **THOMSON-CSF, 173, Boulevard Haussmann,
F-75379 Paris Cedex 08 (FR)**

(72) Inventeur: **Ta Hong, Anh, THOMSON-CSF SCPI 173, bld
Haussmann, F-75360 Paris Cedex 08 (FR)**

(74) Mandataire: **Turlèque, Clotilde et al, THOMSON-CSF
SCPI 173, Bld Haussmann, F-75379 Paris Cedex 08 (FR)**

## Description

La présente invention concerne un dispositif de limitation d'un signal de luminance destiné notamment à protéger les étages de puissance d'un émetteur de télévision (Monochrome ou couleurs) contre les surcharges en cas de modulation positive, et à éviter de perturber la transmission du son en FM, en cas de modulation négative.

Il est connu de limiter un signal par un écrêteur à diode, mais ce type de dispositif a pour inconvénient d'avoir une zone de fonctionnement non linéaire au voisinage du seuil de limitation. Pour que la distorsion du signal soit négligeable, il faut que celui-ci ait une amplitude typique de plusieurs dizaines de volts.

Pour la télévision en couleurs, un signal de chrominance, constitué d'une sous-porteuse modulée, est additionné au signal de luminance. Il doit être transmis sans être altéré par le limiteur. Cela est réalisé par un filtre passe-bande shuntant le limiteur.

Il est connu de remédier à cette non linéarité par l'utilisation d'amplificateurs opérationnels. Il est décrit dans le brevet US 3 393 369 un dispositif limiteur comportant un premier amplificateur opérationnel muni de deux boucles de contre-réaction, une première boucle définissant une première valeur de gain en tension, et une deuxième boucle définissant une deuxième valeur, pratiquement nulle, quand le signal dépasse un seuil réglable. Cette deuxième boucle comporte en série une diode et un deuxième amplificateur opérationnel. Lorsque le signal dépasse le seuil fixé la diode se débloque et fournit un fort courant de contre-réaction à l'entrée du premier amplificateur opérationnel, son gain est alors pratiquement nul, le signal restitué par sa sortie est écrêté.

L'invention a pour objet de réaliser un écrêtage avec une très faible zone de non-linéarité, en n'utilisant qu'un seul amplificateur opérationnel.

Pour les émetteurs couleurs il comporte, comme dans l'art antérieur, un filtre transmettant le signal de chrominance.

Selon l'invention, un dispositif de limitation d'un signal de luminance, utilisable notamment dans un émetteur de télévision, comporte des moyens d'écrêtage du signal de luminance au-dessus d'une valeur de seuil déterminée, des moyens de réglage de la valeur de ce seuil, et est caractérisé en ce qu'il comporte en amont des moyens d'écrêtage, des moyens d'amplification dont le gain augmente lorsque l'amplitude du signal atteint le seuil d'écrêtage.

L'invention sera mieux comprise et d'autres caractéristiques apparaîtront à l'aide de la description ci-après et des schémas s'y rapportant, sur lesquels:

La fig. 1 représente un mode de réalisation du dispositif selon l'invention.

Les fig. 2 à 4 représentent les signaux permettant d'expliquer le fonctionnement du dispositif de la fig. 1.

Les fig. 5 à 7 représentent les signaux permettant d'expliquer les mesures faites sur un exemple de réalisation.

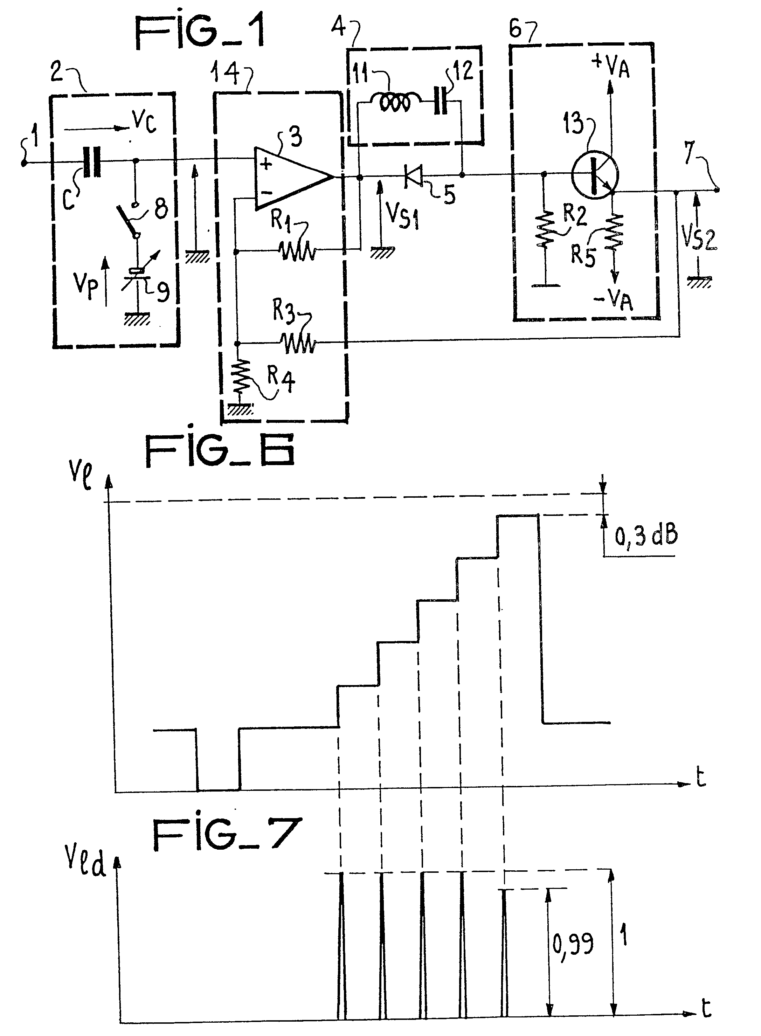

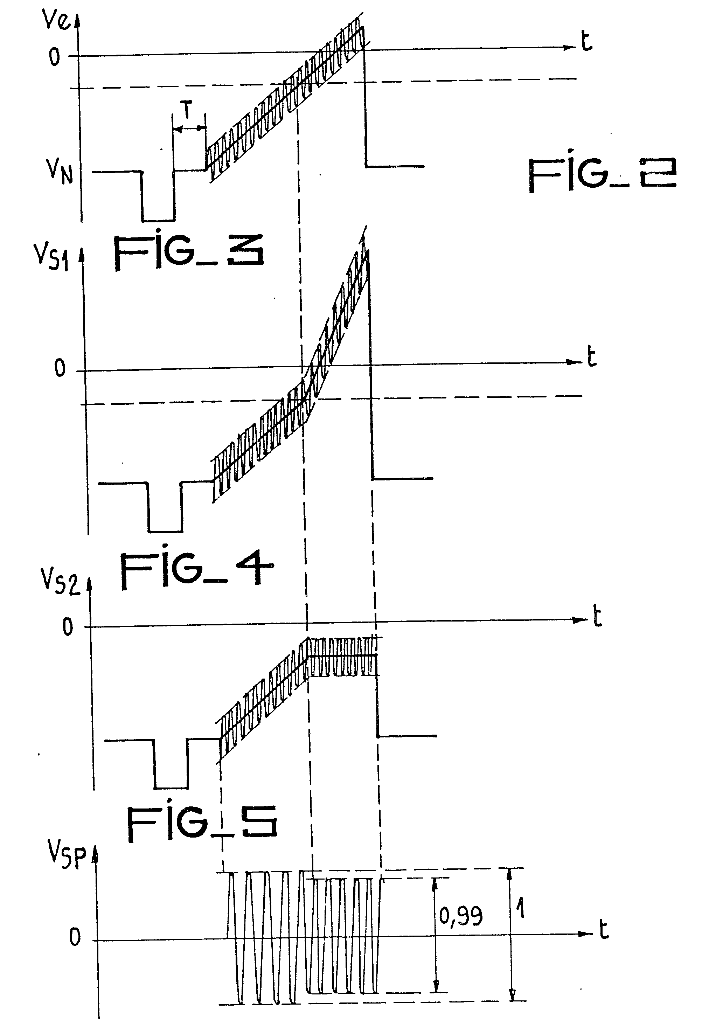

Sur la fig. 1, des moyens 2 de réglage du seuil de limitation reçoivent, sur la borne d'entrée 1 du dispositif une tension composée de l'addition d'un signal de luminance, et d'un signal de chrominance s'il s'agit de télévision couleurs (fig. 2). Ces signaux sont transmis par une capacité C à la sortie des moyens 2. Celle-ci est reliée par un interrupteur 8 à la borne négative d'un générateur 9 de tension continue $V_p$ négative par rapport au potentiel de référence.

L'interrupteur 8 est commandé en synchronisme avec le signal de luminance, de telle sorte qu'il se ferme pendant la durée du palier du noir, T sur la fig. 2. La capacité se charge donc à une tension $V_c$ égale à la tension du palier du noir, moins la tension $V_p$. Le signal de luminance $V_e$ appliqué à la sortie des moyens 2 a ainsi une tension de palier du noir $V_N$ réglable en agissant sur la valeur de $V_p$. Si $V_p$ change de valeur l'ensemble du signal de luminance est décalé.

Ce signal est appliqué à l'entrée des moyens d'amplification 14 constitués d'un amplificateur opérationnel 3 et des résistances $R_3$, $R_4$ et $R_1$. La borne d'entrée des moyens 14 est l'entrée non inversante (+) de l'amplificateur opérationnel 3.

L'entrée inversante (−) de l'amplificateur 3 est reliée d'une part à la sortie 7 du dispositif par la résistance $R_3$ pour former une première boucle de contre-réaction, d'autre part à la sortie de l'amplificateur 3 par la résistance $R_1$ pour former une deuxième boucle de contre-réaction. En outre, cette entrée est reliée au potentiel de référence par la résistance $R_4$.

La sortie de l'amplificateur 3 constitue la sortie des moyens 14. Celle-ci est reliée à travers une diode 5, dans le sens cathode-anode, à l'entrée d'un amplificateur 6. Celui-ci a un gain unité. Il est constitué par un transistor NPN, monté en collecteur commun. La base du transistor constitue l'entrée de l'amplificateur et est reliée au potentiel de référence par une résistance $R_2$. Le collecteur est relié directement à la borne positive de l'alimentation (+$V_A$). L'émetteur est relié, à travers une résistance $R_5$, à la borne (−$V_A$) d'une alimentation négative par rapport au potentiel de référence. Il constitue la sortie de l'amplificateur 6 et de l'ensemble du dispositif.

La diode 5 et la résistance $R_2$ constituent un écrêteur. Le potentiel d'anode de la diode 5 est voisin de OV en négligeant la tension créée par le courant de polarisation de la base du transistor (13) dans la résistance $R_2$. Quand la tension $V_{S1}$ en sortie de l'amplificateur 3 dépasse cette valeur la diode 5 est bloquée. Le signal de luminance n'est plus transmis. Pour que le signal de chrominance ne soit pas affecté, la diode est shuntée par un filtre passe-bande 4, constitué d'une bobine d'inductance 11 et d'un condensateur 12, accordé sur la fréquence de la sous-porteuse de chrominance.

Le fonctionement du dispositif est le suivant:

On distingue deux cas, selon l'état de la diode
5.

– Premier cas: le signal arrivant sur la cathode de
la diode a une tension inférieure à la tension présente au repos sur l'anode. La diode est passante,
les signaux sont transmis. Les variations de la
tension $V_{S1}$ en sortie de l'amplificateur 3 et en
sortie 7 de l'amplificateur 6 sont égales puisque
l'amplificateur 6 a un gain unité. Tout se passe
comme si les résistances $R_1$ et $R_3$ étaient en parallèle. Soit $V_{S2}$ la tension en sortie du dispositif et
$V_e$ la tension à l'entrée de l'amplificateur 3.

Elles vérifient la relation suivante:

$$\frac{V_{S2}}{V_e} \simeq \frac{V_{S1}}{V_e} \simeq 1 + \frac{R_1 \cdot R_3}{(R_1 + R_3)} \cdot R_4$$

Les valeurs des résistances sont choisies telles
que: $R_3 \ll R_1$,

$R_4 \ll R_1$, et $R_3 \simeq R_4$ alors $\dfrac{V_{S2}}{V_e} \simeq \dfrac{V_{S1}}{V_e} \simeq 2$

Ce gain est le même pour le signal de luminance et le signal de chrominance.

– Deuxième cas: la diode 5 est bloquée parce que
le signal a une amplitude plus importante ou bien
parce que l'ensemble du signal a été décalé à un
potentiel supérieur en agissant sur la valeur de la
tension $V_p$ comme cela a été expliqué précédemment. Le signal de luminance n'est plus transmis
à l'amplificateur 6. Par contre le signal de chrominance traverse le filtre 4. Il est amplifié comme
dans le premier cas. A cause de l'isolement provoqué par la diode, le signal de luminance en sortie 7 n'évolue plus, il reste à un niveau constant
auquel s'additionne le signal de chrominance
(fig. 4). La deuxième boucle de contre-réaction
n'est plus active pour le signal de luminance. La
résistance $R_3$ voit à la sortie 7 un générateur de
tension continue à faible résistance interne. Tout
se passe comme si $R_3$ était en parallèle avec $R_4$.
Le gain en tension, pour le signal de luminance vu
en sortie de l'amplificateur 3, est alors:

$$\frac{V_{S1}}{V_e} \simeq 1 + R_1 \cdot \frac{(R_3 + R_4)}{R_3 \cdot R_4}$$

La valeur de $R_1$ est choisie par exemple telle que

$R_1 \simeq 10 \cdot R_3$

$R_1 \simeq 10 \cdot R_4$

alors $\dfrac{V_{S1}}{V_e} \simeq 21$

Le signal de luminance subit une amplification
environ dix fois plus importante que dans le premier cas.

Considérons maintenant la zone de fonctionnement transitoire. Lorsque la diode commence
à se bloquer sa résistance dynamique augmente,
ceci diminue la contre-réaction ramenée par $R_3$,
et par conséquent augmente le gain en sortie de
l'amplificateur 3. Le blocage de la diode s'accélère. Il suffit alors d'une faible variation de la tension d'entrée $V_e$ pour bloquer complètement la
diode. Ainsi la zone de transition où le fonctionnement est non linéaire, est très réduite.

Grâce à l'amplificateur 6 l'impédance de sortie
est de faible valeur, mais la présence de l'amplificateur 6 n'est pas indispensable, il est à la portée
de l'homme de l'art de simplifier le dispositif en
supprimant le transistor 13 et la résistance $R_5$. La
sortie du dispositif est alors constituée par le
point commun à la diode 5 et à la résistance $R_2$.

Les mesures réalisées sur un tel dispositif montrent que le taux de distorsion de non-linéarité est
inférieur à 1% lorsque le seuil de limitation est réglé à 0,3 dB au-dessus de la crête du signal de luminance. Sur la fig. 6 a été représenté le signal de
luminance $V_1$ utilisé et sur la fig. 7 le même signal,
après différentiation, $V_{1d}$, pour faire apparaître et
comparer les amplitudes des différents échelons.

Le taux de distorsion de gain différentiel affectant la sous-porteuse $V_{SP}$ reste inférieur à 196
au-delà de la limitation (Fig. 5).

L'invention n'est pas limitée au mode de réalisation décrit et représenté, en particulier il est à
la portée de l'homme de l'art de réaliser différemment le réglage du niveau d'écrêtage. Par
exemple le générateur 9 peut être connecté autrement. L'interrupteur 8 est relié directement à
la borne de référence des alimentations et le générateur 9 est mis en série avec la résistance $R_2$.
En agissant sur la tension fournie par ce générateur, on peut modifier la tension présente, au repos sur l'anode de la diode 5, et ainsi régler le niveau de limitation de l'amplitude du signal de luminance.

D'autre part il est à la portée de l'homme de
l'art de réaliser différemment l'amplificateur 6,
par exemple avec un transistor PNP; ou d'inverser la diode 5 pour limiter des signaux de luminance négatifs.

**Revendications**

1. Dispositif de limitation d'un signal de luminance, utilisable notamment dans un émetteur
de télévision, comportant des moyens (5) d'écrêtage du signal de luminance au-dessus d'une valeur de seuil déterminée, des moyens (2) de réglage de la valeur de ce seuil, caractérisé en ce
qu'il comporte, en amont des moyens d'écrêtage, des moyens d'amplification (14) dont le gain
augmente lorsque l'amplitude du signal atteint le
seuil d'écrêtage.

2. Dispositif selon la revendication 1, caractérisé en ce que les moyens d'amplification (14) comportent deux boucles de contre-réaction, l'une définissant une première valeur de gain de tension lorsque le signal est inférieur au seuil d'écrêtage, l'autre définissant une deuxième valeur de gain très supérieure à la première valeur lorsque le signal dépasse le seuil d'écrêtage.

3. Dispositif selon la revendication 2, caractérisé en ce que les moyens d'amplification (14) comportent un amplificateur opérationnel (3) muni d'une première boucle de contre-réaction (R$_1$) reliant son entrée inversante (–) à sa sortie, et une deuxième boucle de contre-réaction (R$_3$) reliant son entrée inversante (–) à la sortie de l'amplificateur opérationnel (3) à travers les moyens d'écrêtage (5).

4. Dispositif selon la revendication 3, caractérisé en ce qu'il comporte un filtre passe-bande (4) accordé sur la fréquence de la sous-porteuse chrominance et shuntant les moyens d'écrêtage (5).

## Patentansprüche

1. Vorrichtung zur Begrenzung eines Luminanzsignals, die insbesondere in einem Fernsehsender verwendbar ist, mit Begrenzermitteln (5) für das Luminanzsignal oberhalb eines bestimmten Schwellwertes, Mitteln (2) zum Einstellen dieses Schwellwertes, dadurch gekennzeichnet, dass sie im Signalweg vor den Begrenzermitteln Verstärkermittel (14) enthält, deren Verstärkung zunimmt, wenn die Amplitude des Signals den Begrenzungsschwellwert erreicht.

2. Vorrichtung nach Anspruch 1, dadurch gekennzeichnet, dass die Verstärkungsmittel (14) zwei Gegenkopplungsschleifen enthalten, von denen die eine einen ersten Spannungsverstärkungswert bestimmt, wenn das Signal kleiner als der Begrenzungsschwellwert ist, während die andere einen zweiten Verstärkungswert festlegt, der sehr viel grösser als der erste ist, wenn das Signal den Begrenzungsschwellwert überschreitet.

3. Vorrichtung nach Anspruch 2, dadurch gekennzeichnet, dass die Verstärkermittel (14) einen Operationsverstärker (3) enthalten, der mit einer ersten Gegenkopplungsschleife (R$_1$), welche seinen invertierenden Eingang (–) mit seinem Ausgang verbindet, und eine zweite Gegenkopplungsschleife (R$_3$) enthält, welcher seinen invertierenden Eingang (–) mit dem Ausgang des Operationsverstärkers (3) über die Begrenzermittel (5) verbindet.

4. Vorrichtung nach Anspruch 3, dadurch gekennzeichnet, dass sie ein Bandpassfilter (4) enthält, welches auf die Frequenz des Chrominanz-Hilfsträgers abgestimmt ist und die Begrenzermittel (5) überbrückt.

## Claims

1. Device for the limitation of a luminance signal, in particular adapted for use in a television transmitter, comprising means (5) for limiting the luminance signal above a determined threshold value, means (2) for adjusting the value of this threshold, characterized in that it comprises, upstream from the limiting means, amplification means (14) the gain of which increases when the amplitude of the signal reaches the limiting threshold.

2. Device according to claim 1, characterized in that the amplification means (14) comprise two negative feedback loops, one of these loops defining a first voltage gain value when the signal is below the limiting threshold, and the other loop defining a second gain value which is substantially higher than the first gain value when the signal exceeds the limiting threshold.

3. Device according to claim 2, characterized in that the amplification means (14) comprise an operational amplifier (3) provided with a first negative feedback loop (R$_1$) connecting its inverting input (–) with its output and a second negative feedback loop (R$_3$) connecting its inverting input (–) with the output of the operational amplifier (3) through the limiting means (5).

4. Device according to claim 3, characterized in that it comprises a band-pass filter (4) tuned to the frequency of the chrominance sub-carrier and shunting the limiting means.

0 057 117

FIG_1

FIG_6

FIG_7

FIG_2

FIG_3

FIG_4

FIG_5